# EUROPEAN PATENT SPECIFICATION

(11) **EP 1 620 883 B1**
(45) Date of publication and mention of the grant of the patent: **08.10.2008**
(21) Application number: 04716586.5
(22) Date of filing: 03.03.2004
(51) Int. Cl.: H01L 21/3065, B23K 26/12, H01L 21/78

(54) **LASER MACHINING USING AN ACTIVE ASSIST GAS**
LASERBEARBEITUNG MIT EINEM AKTIVEN HILFSGAS
USINAGE LASER AU MOYEN D'UN GAZ AUXILIAIRE ACTIF

(30) Priority: 04.03.2003 GB 0304900
(43) Date of publication of application: 01.02.2006
(73) Proprietor: Xsil Technology Limited, Dublin 2 (IE)
(72) Inventor: BOYLE, Adrian, County Kildare (IE)
(74) Representative: Want, Clifford James
(86) International application number: PCT/EP2004/002149
(87) International publication number: WO 2004/079810

(56) References cited:
- WO-A-97/24768
- US-A- 3 679 502
- US-A- 3 866 398
- US-A- 4 331 504
- US-A- 4 617 086
- US-A- 4 731 158
- US-A1- 2002 088 780
- US-B1- 6 350 391

## Description

This invention relates to method of laser dicing according to the preamble of claim 1. US 3866398 discloses such a method wherein a reagent gas such as SF₆ is disclosed as being introduced locally to a machining region during a laser scribing process. The reagent gas reacts with high temperature vapour ejected from a substrate material during laser machining to produce gaseous compounds that do not redeposit as solid debris on the substrate to be machined.

It is known that etching of a silicon wafer substrate in an SF₆ environment results in clean and smooth etching of the silicon substrate.

Also, the presence of SF₆ during laser machining improves both the quality and efficiency of the material removal process. However, although, the presence of this gas assists the material removal, typically this does not allow laser machining at a rate to enable sufficiently high throughput machining for manufacturing.

US 3679502 describes a method for non-localised etching of silicon wafer substrates heated to a temperature in a region of 950 to 1250 °C in an SF₆ environment. Fluorine radicals produced at such elevated temperatures etch the silicon surface resulting in a smooth clean surface.

US 4331504 discloses the utilisation of a CO₂ laser vibrationally to excite SF₆ molecules for directional non-localised etching of a masked wafer substrate. The CO₂ laser energy is sufficiently low so as to prevent direct laser ablation of the wafer substrate.

US 4617086 describes a method for fast local etching of a silicon substrate in an SF₆ environment using a continuous laser at a wavelength of 0.6 microns or less to photo-dissociate the SF₆ molecule. The laser power density is in the region of 6 × 10⁵ W/cm² and is below an ablation threshold of silicon and so etching is primarily preformed by the interaction between the silicon substrate and fluorine radicals produced when the laser is on.

US 4731158 discloses a mixture of H₂ and a fluorine-containing molecule such as NF₃, SF₆ and COF₂ used in order to improve a speed of laser photo-dissociative etching of silicon relative to performing a same etching process in an environment of just fluorine-containing molecules. Etching of the substrate material is performed by fluorine radicals produced as a result of the photo-dissociation process.

WO 97/24768 discloses a method of simultaneously laser grooving silicon in a halogen, preferably chlorine, environment to reduce deposition of debris on the workpiece, and doping of the grooves with a gaseous boron or phosphorous fluorine compound.

It is an object of the present invention at least to mitigate the aforesaid deficiencies in the prior art.

It is a particular object of the present invention to utilise the advantages of laser machining in an SF₆ environment for a laser dicing process that results in low debris laser machining and/or superior strength of diced substrate parts. This superior die strength arises from the high quality machining achievable using an SF₆ assist gas during the laser machining process.

According to the present invention there is provided a method according to claim 1.

Advantageously, the method is for dicing a silicon wafer, such that use of the assist gas increases strength of resultant dies.

Preferably, the step of providing a halogen environment comprises providing a fluorine environment as the active assist gas and the step of reacting the active assist gas with the silicon workpiece comprises reacting the fluorine with the silicon workpiece to form gaseous silicon tetrafluoride (SiF₄).

Conveniently, the step of laser dicing the workpiece comprises wafer dicing.

Preferably, the method includes an additional step of providing gas extraction means for removing at least one of gas-borne debris and waste gas from the environment of the workpiece.

Advantageously, the method includes a further step, after the step of laser dicing the workpiece, of cleaning the workpiece of residues generated by the laser dicing.

Conveniently, the step of cleaning the workpiece comprises the step of dry wiping the workpiece.

Alternatively, or in addition, the step of cleaning the workpiece comprises a water spin-rinse-dry process.

Alternatively, or in addition, the step of cleaning the workpiece comprises the step of laser cleaning the workpiece.

Advantageously, the step of laser cleaning the workpiece comprises scanning the workpiece with a defocused or low energy laser beam.

Conveniently, the step of laser cleaning the workpiece comprises laser cleaning the workpiece in an air environment.

Preferably, the step of laser cleansing the workpiece comprises laser cleaning the workpiece in an active assist gas environment.

Preferably, the active assist gas is fluorine or fluorine-based.

Conveniently, fluorine radicals are produced by laser photo-dissociation of sulphur hexafluoride at the silicon workpiece.

Conveniently, where the workpiece is a silicon substrate with active devices on a first major face thereof, the step of providing a halogen environment for the workpiece comprises an initial step of mounting the substrate with the first major face on tape frame means and the step of dicing the workpiece comprises dicing the substrate from a second major face opposed to the first major face.

Advantageously, the laser source means comprises a diode-pumped laser operating at a second, third or fourth harmonic at a wavelength of less than 0.55 microns.

Conveniently, the laser beam delivery means comprises a galvanometer with a scan lens and an XY motion stage for positioning the workpiece in relation to the laser beam.

Advantageously, the apparatus further comprises tape frame means for mounting the workpiece for machining the workpiece from a second major face of the workpiece opposed to a first face of the workpiece having active devices thereon.

The invention will now be described, by way of example, with reference to the accompanying drawings in which:
Figure 1 is a graph of machining speed as ordinates vs. wafer thickness as abscissa for laser machining according to the invention and according to the prior art;
Figure 2 is a graph of survival probability (%PS) as ordinates vs. die strength (N/mm²) as abscissa for patterned wafers using laser machining according to the invention and according to the prior art and using saw street cutting techniques;
Figure 3 shows plots of average, maximum and minimum die strength values for laser and saw cut silicon die;
Figure 4 is a schematic diagram of a laser machining apparatus according to the present invention.

In the Figures like reference numerals denote like parts.

The present invention relates particularly to laser dicing of a silicon substrate at a laser power density above the silicon ablation threshold in an SF₆ environment. Silicon material is primarily removed from the wafer substrate by the laser ablation process. The addition of SF₆ results in an increase in laser dicing speed and also an increase in die strength of laser machined die due to an improvement in machining quality. This improvement may be compared with improved etching with SF₆ in the prior art, namely, the surface of features laser machined in an SF₆ environment is smoother than that obtained with laser machining in air. However, in the present invention, etching of the silicon is substantially confined to a localised region of the workpiece on which the laser is focused. Also, material ejected during the laser ablation process reacts with the SF₆ environment and can be removed from a machining site in a gaseous form rather than being re-deposited as solid debris around the laser machining site.

Silicon reacts vigorously with all halogens to form silicon tetrahalides. It reacts with fluorine (F₂), chlorine (Cl₂), bromine (Br₂) and iodine (I₂) to form respectively silicon tetrafluoride (SiF₄), silicon tetrachloride (SiCl₄), silicon tetrabromide (SiBr₄), and silicon tetra-iodide (SiI₄). The reaction with fluorine takes place at room temperature but the others require heating to over 300°C.

Si + 2F₂→SiF₄ (gas) Reaction 1

It is known that molten silicon reacts with sulphur hexafluoride (SF₆) according to the following reaction:

2SF₆ + 3Si→2S + 3SiF₄ (in the presence of laser light) Reaction 2

As the reaction of SF₆ and silicon is not spontaneous, occurring only at energies above the melting threshold of silicon, it may be very localized and thus suitable for one-step silicon micro-machining applications such as wafer dicing, via drilling and surface patterning.

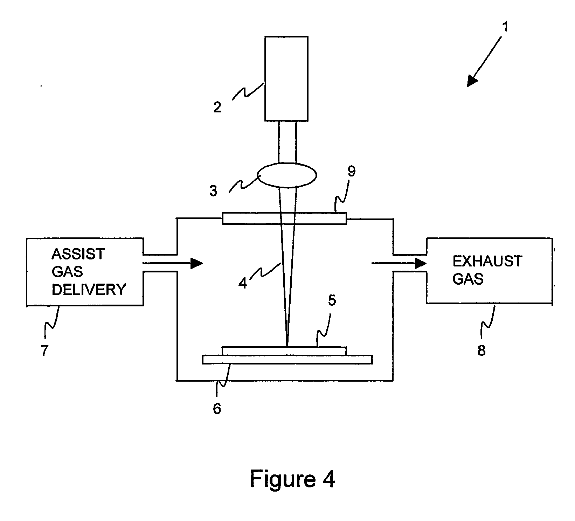

Referring to figure 4, a laser dicing system 1 of the present invention includes a diode-pumped laser 2 operating in the second, third, or fourth harmonic, at a wavelength of less than 0.55 microns, and a beam delivery system 3 that delivers the laser beam to the surface of a silicon wafer 5. Wavelengths in the regions of 366nm or 355nm are suitable. The silicon wafer may be blank or may have different layers patterned on it. The beam delivery system includes a galvanometer with a scan lens to direct the beam within an available field of view while an XY motion stage 6 is used to position the silicon wafer 5 to be machined. The system includes a gas delivery system 7 and an extraction system 8 that delivers SF₆ gas to the wafer surface and captures airborne debris and waste gas subsequent to laser machining, respectively. The laser beam may be directed to the desired machining site on the wafer 5 through a laser window 9 in an enclosure for enclosing an active assist gas around the wafer 5. To machine the wafer, the laser beam 4 heats the silicon wafer 5 such that its temperature is sufficient for Reaction 2 to take place. Fluorine radicals dissociated from SF₆ by the laser then etch the silicon in Reaction 1 by bonding with the silicon to form gaseous silicon tetrafluoride (SiF₄). Due to the reaction with the SF₆ gas, the silicon machining rate is significantly faster than that achieved when an active assist gas is not used.

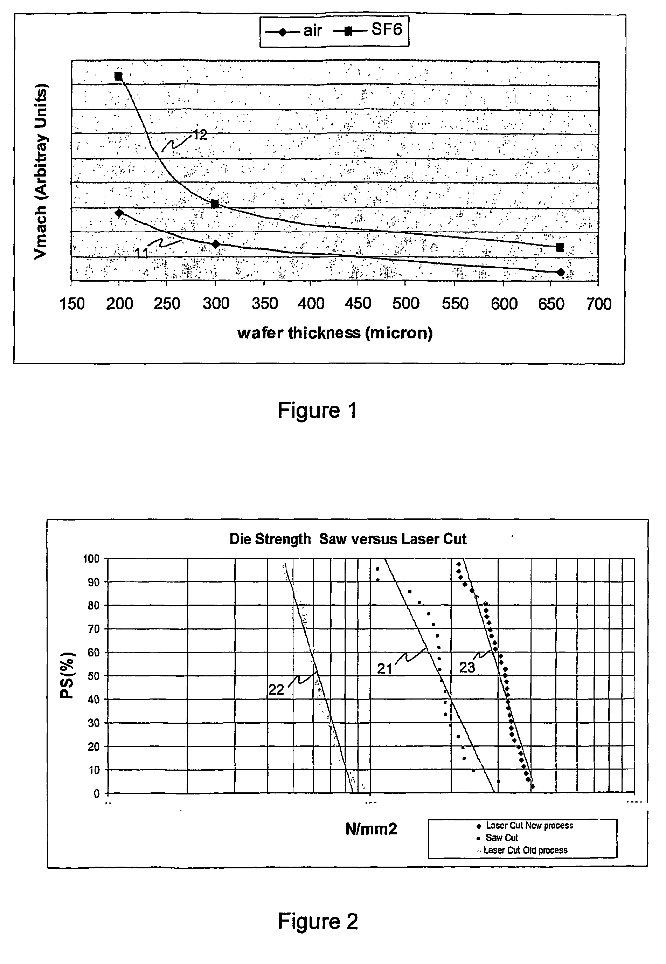

An example of the advantage in the machining speed gained when SF₆ is used as an assist gas during laser machining is shown in Figure 1, in which plot 11 is for laser machining in air and plot 12 is for laser machining in a SF₆ environment. As can be seen, the machining speed for a wafer substrate is faster in a SF₆ environment for all thicknesses of wafer studied and for wafers less than 250 microns thick is more than three times faster in an SF₆ environment than in air.

The die strength, as measured using a known Weibull die strength test, of components which are diced using SF₆ as an active assist gas during laser machining is higher than that achieved when an assist gas is not used. That is, it is found that there is a significant increase in the strength of silicon die tested subsequent to laser machining using SF₆ as an assist gas. Figure 2 shows plots, for saw-cut die 21, laser machined die using an air environment 22 and laser machined die using a SF₆ environment 23, of the probability of survival vs. the pressure applied to break the die. It can be seen that the die strength for laser machined die in an air environment, plot 22, is less than the strength of traditional saw-cut die, plot 21, whereas the strength of die laser machined in a SF₆ environment, plot 23, is greater than that of saw-cut die, plot 21. In fact, it is found that using a beam overlap of 70%, the die strength of laser-machined components is up to 4.8 times stronger than that of components machined without the use of gas assist. Moreover, it was also found that die cut in SF₆ gas were 1.65 times stronger than die cut using a saw cutting technique.

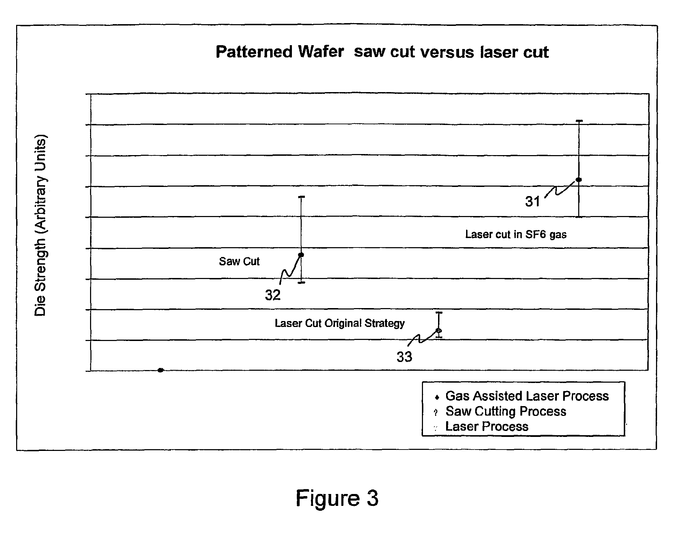

Referring to Figure 3, laser machining with SF₆ as an active assist gas resulted in average die strength value 31 in excess of 300MPa compared to a value 32 of 185MPa for a conventional saw cutting technique and a value 33 of 65MPa for laser machining in the absence of an assist gas.

When silicon is machined with SF₆ as an assist gas, the majority of the by-products are in gaseous form and are vented away, but some solid debris remains and may be re-deposited on the wafer. This debris can be easily removed with a dry wipe process.

If for any reason the application of the dry wipe method is not applicable or desirable, removal of this solid debris is possible by defocusing the laser beam and scanning the contaminated area at a higher speed than used for machining, freeing debris from the surface and permitting it to be captured by the extraction system 8. It may be necessary to scan the same area of the workpiece or substrate more than once in order to perform satisfactory cleaning, however, during cleaning the power of the laser beam is sufficiently low to prevent damage to the silicon or any other layer on the wafer. It is not necessary to use an assist gas for this cleaning, but the efficiency of the process is increased if SF₆ is used.

It is possible that the top layers of the wafer may be photosensitive, so that it is not practical to use a scanning laser beam on the top surface of the wafer. In this case it is possible to process the wafer from a backside of the wafer.

Specifically, using a vision system to align a wafer for machining from a bottom of the wafer, the wafer may be mounted face downward on a tape. Typically, the tape is transparent to visible radiation. With a vision system in registration with the laser system, the laser beam can be delivered to a back surface of the wafer. This ensures all debris generated is on the back of the wafer.

Once diced in this manner the wafer may be laser cleaned ( dry) or washed, without components on the front of the wafer being contacted by water.

In a further embodiment of the invention the wafer is enclosed in a closed chamber. Gas flow into and out of the chamber is regulated to ensure efficient machining and control of gas usage. A valve system may also be used to ensure gas flow into the chamber is controlled so that sufficient gas is delivered during the laser "ON" period.

Finally, apparatus to remove and recirculate gas not consumed in the reaction may include facilities for extraction and filtering of reaction by-products and for returning un-reacted gas to the reaction area.

Although the invention has been described using fluorine derived from SF₆, to machine silicon, it will be understood that other halogens and other sources of halogens may be used, for example, CF₄. Moreover, it will be understood that the invention has application to machining other semiconductor materials with appropriate assist gases which enhance machining.

The invention provides the advantages, in the use of UV lasers, operating particularly in the range of 366nm or 355nm, for dicing and machining silicon, and other semiconductors, with high pulse repetition frequency and using multiple passes, as described, for example, in WO 02/34455, where the assist gas is used to enhance the dicing or machining process such that the speed of the process is improved, the nature of the debris is modified to enable more efficient cleaning and where the process itself, using the assist gas, provides die with higher die strength than that achievable without the use of assist gas.

Typical examples of where the invention provides a major advantage are in the manufacture of, for example, smart cards, stacked integrated circuits and integrated circuits. For integrated circuits, die strength is critical to short and long term reliability of the diced component.

## Claims

1. A method of laser dicing a silicon workpiece (5) comprising the steps of:
a. providing a laser beam (4),
b. providing a halogen environment for the silicon workpiece to form an active assist gas for the laser dicing by providing a halogen, or source of halogen, environment and dissociating at least some of the halogen, or source of halogen, with the laser beam to form halogen radicals as the active assist gas; and
c. focusing the laser beam onto the silicon workpiece at a power density above an ablation threshold of silicon in order to laser dice the silicon workpiece in the presence of the assist gas so that the assist gas reacts with the silicon workpiece at or near a focus of the laser beam such that laser dicing speed is increased and strength of the diced workpiece is increased due to an improvement in dicing quality.
wherein the step of providing a halogen environment comprises a step of providing a sulphur hexafluoride (SF₆) environment,
**characterised in that** the step of providing a halogen environment also comprises a step of dissociating at least some of the sulphur hexafluoride with the laser beam to form fluorine radicals as the active assist gas, and that the laser beam has a wavelength of less than 0.55 microns.

2. A method as claimed in claim 1, for dicing a silicon wafer, such that use of the assist gas increases strength of resultant dies.

3. A method as claimed in claims 1 or 2, wherein the step of providing a halogen environment comprises providing a fluorine environment as the active assist gas and the step of reacting the active assist gas with the silicon workpiece comprises reacting the fluorine with the silicon workpiece to form gaseous silicon tetrafluoride (SiF₄).

4. A method as claimed in any of the preceding claims, wherein the step of laser dicing the workpiece comprises wafer dicing.

5. A method as claimed in any of the preceding claims, including an additional step of providing gas extraction means for removing at least one of gas-borne debris and waste gas from the environment of the workpiece.

6. A method as claimed in any of the preceding claims, including a further step, after the step of laser dicing the workpiece, of cleaning the workpiece of residues generated by the laser dicing.

7. A method as claimed in claim 6, wherein the step of cleaning the workpiece comprises the step of dry wiping the workpiece.

8. A method as claimed in claims 6 or 7, wherein the step of cleaning the workpiece comprises a water spin-rinse-dry process.

9. A method as claimed in any of claims 6 to 8, wherein the step of cleaning the workpiece comprises the step of laser cleaning the workpiece.

10. A method as claimed in claim 9, wherein the step of laser cleaning the workpiece comprises scanning the workpiece with a defocused or low energy laser beam.

11. A method as claimed in claims 9 or 10, wherein the step of laser cleaning the workpiece comprises laser cleaning the workpiece in an air environment.

12. A method as claimed in any of claims 9 or 10, wherein the step of laser cleaning the workpiece comprises laser cleaning the workpiece in an active assist gas environment.

13. A method as claimed in claim 12, wherein the active assist gas is fluorine or fluorine-based.

14. A method as claimed in any of the preceding claims, wherein fluorine radicals are produced by laser photo-dissociation of sulphur hexafluoride at the silicon workpiece.

15. A method as claimed in any of the preceding claims, wherein where the workpiece is a silicon substrate with active devices on a first major face thereof, the step of providing a halogen environment for the workpiece comprises an initial step of mounting the substrate with the fist major face on tape frame means and the step of dicing the workpiece comprises dicing the substrate from a second major face opposed to the first major face.

## Patentansprüche

1. Verfahren zum Laserschneiden eines Siliziumwerkstücks (5) , wobei das Verfahren die folgenden Schritte umfasst:
a) das Bereitstellen eines Laserstrahls (4);
b) das Bereitstellen einer Halogenumgebung für das Siliziumwerkstück, um ein aktives Schneidgas für das Laserschneiden durch das Bereitstellen einer Halogenumgebung oder einer Umgebung einer Halogenquelle zu bilden und Dissoziation mindestens eines Teils des Halogens oder der Halogenquelle mit dem Laserstrahl, so dass Halogenradikale als das aktive Schneidgas gebildet werden; und
c) das Fokussieren des Laserstrahls auf das Siliziumwerkstück mit einer Leistungsdichte oberhalb eines Ablationsschwellenwerts von Silizium, um das Siliziumwerkstück in Gegenwart des Schneidgases mittels Laser zu zerschneiden, so dass das Schneidgas mit dem Siliziumwerkstück an dem Fokus oder nahe dem Fokus des Laserstrahls reagiert, so dass die Geschwindigkeit des Laserschneidens erhöht wird und so dass die Stärke des zerteilten Werkstücks durch eine Verbesserung der Zerteilungsqualität verbessert wird;
wobei der Schritt des Bereitstellens einer Halogenumgebung einen Schritt des Bereitstellens einer Schwefelhexafluorid-Umgebung (SF₆-Umgebung) umfasst;
**dadurch gekennzeichnet, dass** der Schritt des Bereitstellens einer Halogenumgebung ferner einen Schritt des Dissoziierens mindestens eines Teils des Schwefelhexafluorids mit dem Laserstrahl umfasst, so dass Fluorradikale als das aktive Schneidgas gebildet werden, und wobei der Laserstrahl eine Wellenlänge von weniger als 0,55 Mikron aufweist.

2. Verfahren nach Anspruch 1 zum Zerteilen eines Siliziumwafers, so dass der Einsatz des Schneidgases die Stärke der resultierenden Chips erhöht.

3. Verfahren nach Anspruch 1 oder 2, wobei der Schritt des Bereitstellens einer Halogenumgebung das Bereitstellen einer Fluorumgebung als aktives Schneidgas umfasst, und wobei der Schritt des Reagierens des aktiven Schneidgases mit dem Siliziumwerkstück das Reagieren des Fluors mit dem Siliziumwerkstück umfasst, so dass gasförmiges Siliziumtetrafluorid (SiF₄) gebildet wird.

4. Verfahren nach einem der vorstehenden Ansprüche, wobei der Schritt des Laserschneidens des Werkstücks das Waferzerteilen umfasst.

5. Verfahren nach einem der vorstehenden Ansprüche, mit dem zusätzlichen Schritt des Bereitstellens einer Gasextrahierungseinrichtung zum Entfernen zumindest von Rückständen in Gas oder Abgasen aus der Umgebung des Werkstücks.

6. Verfahren nach einem der vorstehenden Ansprüche, wobei das Verfahren nach dem Schritt des Laserschneidens des Werkstücks den weiteren Schritt des Säuberns des Werkstücks von durch das Laserschneiden erzeugten Rückständen umfasst.

7. Verfahren nach Anspruch 6, wobei der Schritt des Säuberns des Werkstücks den Schritt des Trockenwischens des Werkstücks umfasst.

8. Verfahren nach einem der Ansprüche 6 oder 7, wobei der Schritt des Säuberns des Werkstücks ein Wassertrockenschleuderverfahren umfasst.

9. Verfahren nach einem der Ansprüche 6 bis 8, wobei der Schritt des Säuberns des Werkstücks den Schritt des Laserreinigens des Werkstücks umfasst.

10. Verfahren nach Anspruch 9, wobei der Schritt des Laserreinigens des Werkstücks das Abtasten des Werkstücks mit einem defokussiertem oder Niederenergie-Laserstrahl umfasst.

11. Verfahren nach Anspruch 9 oder 10, wobei der Schritt des Laserreinigens des Werkstücks das Laserreinigen des Werkstücks in einer Luftumgebung umfasst.

12. Verfahren nach einem der Ansprüche 9 oder 10, wobei der Schritt des Laserreinigens des Werkstücks das Laserreinigen des Werkstücks in einer aktiven Schneidgasumgebung umfasst.

13. Verfahren nach Anspruch 12, wobei es sich bei dem aktiven Schneidgas um Fluor handelt oder um ein Gas auf Fluorbasis.

14. Verfahren nach einem der vorstehenden Ansprüche, wobei Fluorradikale durch optische Laserdissoziation von Schwefelhexafluorid an dem Siliziumwerkstück erzeugt werden.

15. Verfahren nach einem der vorstehenden Ansprüche, wobei für den Fall, dass es sich bei dem Werkstück um ein Siliziumsubstrat mit aktiven Bausteinen auf einer ersten Hauptoberfläche des Werkstücks handelt, der Schritt des Bereitstellens einer Halogenumgebung für das Werkstück einen anfänglichen Schritt des Anbringens des Substrats mit der ersten Hauptoberfläche auf einer Bandrahmeneinrichtung umfasst, und wobei der Schritt des Zerteilens des Werkstücks das Zerteilen des Substrats von einer zweiten Hauptoberfläche umfasst, die der ersten Hauptoberfläche gegenüberliegt.

## Revendications

1. Procédé de découpage en dés par laser d'une pièce de fabrication en silicium (5) comprenant les étapes consistant à :
a. fournir un rayon laser (4)
b. fournir un environnement d'halogène pour la pièce de fabrication en silicium pour former un gaz de soufflage actif pour le découpage en dés par laser en fournissant un environnement d'halogène, ou de source d'halogène et à dissocier au moins une partie de l'halogène, ou de la source d'halogène, avec le rayon laser pour former des radicaux d'halogène comme gaz de soufflage actif ; et
c. concentrer le rayon laser sur la pièce de fabrication en silicium à une densité de puissance supérieure à un seuil d'ablation du silicium afin de découper en dés par laser la pièce de fabrication en silicium en présence du gaz de soufflage de sorte que le gaz de soufflage réagisse avec la pièce de fabrication en silicium au niveau de ou près d'un foyer du rayon laser de sorte que la vitesse de découpage en dés par laser est augmentée et la résistance de la pièce de fabrication découpée en dés est augmentée en raison d'une amélioration de la qualité du découpage en dés,
dans lequel la fourniture d'un environnement d'halogène comprend une étape consistant à fournir un environnement d'hexafluorure de soufre (SF₆), **caractérisé en ce que** la fourniture d'un environnement d'halogène comprend également un étape consistant à dissocier au moins une partie de l'hexafluorure de soufre avec le rayon laser pour former des radicaux de fluor comme gaz de soufflage actif, et **en ce que** le rayon laser a une longueur d'onde de moins de 0,55 micron.

2. Procédé selon la revendication 1, pour découper en dés une tranche de silicium, de sorte que l'utilisation du gaz de soufflage augmente la résistance des dés obtenus.

3. Procédé selon la revendication 1 ou 2, dans lequel la fourniture d'un environnement d'halogène comprend une étape consistant à fournir un environnement de fluor comme gaz de soufflage actif et la réaction du gaz de soufflage actif avec la pièce de fabrication en silicium comprend l'étape consistant à faire réagir le fluor avec la pièce de fabrication en silicium pour former du tétrachlorure de silicium (SiF₄) gazeux.

4. Procédé selon l'une quelconque des revendications précédentes, dans lequel le découpage en dés par laser de la pièce de fabrication comprend le découpage en dés de tranches.

5. Procédé selon l'une quelconque des revendications précédentes, comprenant une étape supplémentaire consistant à fournir des moyens d'extraction de gaz pour retirer au moins l'un des débris en suspension dans le gaz et d'un gaz de fumées de l'environnement de la pièce de fabrication.

6. Procédé selon l'une quelconque des revendications précédentes, comprenant une étape supplémentaire, après le découpage par laser de la pièce de fabrication, consistant à nettoyer la pièce de fabrication des résidus générés par le découpage en dés par laser.

7. Procédé selon la revendication 6, dans lequel le nettoyage de la pièce de fabrication comprend l'étape consistant à essuyer à sec la pièce de fabrication.

8. Procédé selon la revendication 6 ou 7, dans lequel le nettoyage de la pièce de fabrication comprend un processus d'essorage/rinçage/séchage à l'eau.

9. Procédé selon la revendication 6 à 8, dans lequel le nettoyage de la pièce de fabrication comprend l'étape consistant à nettoyer par laser la pièce de fabrication.

10. Procédé selon la revendication 9, dans lequel le nettoyage par laser de la pièce de fabrication comprend l'étape consistant à balayer la pièce de fabrication avec un rayon laser défocalisé ou à basse énergie.

11. Procédé selon la revendication 9 ou 10, dans lequel le nettoyage par laser de la pièce de fabrication comprend l'étape consistant à nettoyer par laser la pièce de fabrication dans un environnement d'air.

12. Procédé selon l'une quelconque des revendications 9 ou 10, dans lequel le nettoyage par laser de la pièce de fabrication comprend l'étape consistant à nettoyer par laser la pièce de fabrication dans un environnement de gaz de soufflage actif.

13. Procédé selon la revendication 12, dans lequel le gaz de soufflage actif est du fluor ou à base de fluor.

14. Procédé selon l'une quelconque des revendications précédentes, dans lequel les radicaux de fluor sont produits par photodissociation laser d'hexafluorure de soufre au niveau de la pièce de fabrication en silicium.

15. Procédé selon l'une quelconque des revendications précédentes, dans lequel la pièce de fabrication est un substrat de silicium avec des dispositifs actifs sur une face majeure de celui-ci, la fourniture d'un environnement d'halogène pour la pièce de fabrication comprend une étape initiale consistant à monter le substrat avec la face majeure de celui-ci sur des moyens de rangée bande et le découpage en dés de la pièce de fabrication comprend l'étape consistant à découper en dés le substrat à partir d'une seconde face majeure opposée à la première face majeure.
